# EUROPÄISCHE PATENTSCHRIFT

(11) **EP 2 356 703 B1**
(45) Veröffentlichungstag und Bekanntmachung des Hinweises auf die Patenterteilung: **14.08.2013**
(21) Anmeldenummer: 09753032.3
(22) Anmeldetag: 05.11.2009
(51) Int. Cl.: H01L 35/30, E04D 13/18

(54) **GEBÄUDEELEMENT, GEBÄUDEHÜLLE UND GEBÄUDE**
BUILDING ELEMENT, BUILDING SHELL AND BUILDING
ÉLÉMENT DE BÂTIMENT, COQUE DE BÂTIMENT ET BÂTIMENT

(30) Priorität: 19.11.2008 DE 102008058250; 26.05.2009 DE 102009022745
(43) Veröffentlichungstag der Anmeldung: 17.08.2011
(73) Patentinhaber: EWALD DÖRKEN AG, 58313 Herdecke (DE)
(72) Erfinder: SCHRÖER, Jörn, 58313 Herdecke (DE)
(74) Vertreter: Von Rohr
(86) Internationale Anmeldenummer: PCT/EP2009/007921
(87) Internationale Veröffentlichungsnummer: WO 2010/057579

(56) Entgegenhaltungen:
- EP-A1- 1 818 992
- WO-A1-03/105240
- WO-A1-2009/092827
- WO-A2-2009/030236
- DE-A1- 19 946 806
- GB-A- 887 202
- JP-A- 2001 132 193
- JP-A- 2004 204 546
- MANEEWAN S ET AL: "Experimental investigation on generated power of thermoelectric roof solar collector" THERMOELECTRICS, 2003 TWENTY-SECOND INTERNATIONAL CONFERENCE ON - ICT LA GRANDE MOTTE, FRANCE AUG. 17-21, 2003, PISCATAWAY, NJ, USA,IEEE, 17. August 2003 (2003-08-17), Seiten 574-577, XP010697379 ISBN: 978-0-7803-8301-2
- KHIRE R A ET AL: "Design of thermoelectric heat pump unit for active building envelope systems" INTERNATIONAL JOURNAL OF HEAT AND MASS TRANSFER, PERGAMON PRESS, GB LNKD- DOI:10.1016/J.IJHEATMASSTRANSFER.2005.04.0 28, Bd. 48, Nr. 19-20, 1. September 2005 (2005-09-01), Seiten 4028-4040, XP004984769 ISSN: 0017-9310

## Beschreibung

Die vorliegende Erfindung betrifft ein Gebäudeelement einer eine Gebäudeaußenhaut aufweisenden oder bildenden Gebäudehülle eines Gebäudes, mit einem unter oder hinter der Gebäudeaußenhaut anzuordnenden Gebäudegrundelement und wenigstens einem dem Gebäudegrundelement zugeordneten thermoelektrischen Generator zur Umwandlung von Wärme, insbesondere Wärmestrahlung, in Strom. Des weiteren betrifft die vorliegende Erfindung ein Gebäudeelement einer Gebäudeaußenhaut einer Gebäudehülle eines Gebäudes, mit einem Außenhautelement. Darüber hinaus betrifft die Erfindung eine Gebäudehülle eines Gebäudes mit wenigstens einem Gebäudeelement der vorgenannten Art sowie ein Gebäude mit einer vorgenannten Gebäudehülle.

Zur Unterscheidung ist darauf hinzuweisen, daß die beiden vorgenannten Gebäudeelemente sich dahingehend unterscheiden, daß das erstgenannte Gebäudeelement ein solches darstellt, das als Teil der Gebäudehülle hinter der äußeren Gebäudeaußenhaut angeordnet ist. Dementsprechend kann es sich bei diesem Gebäudeelement beispielsweise um eine Tragkonstruktion oder ein Teil davon, eine Gebäudeplatte, eine Dämmplatte oder eine Unterspann- oder Unterdeckbahn handeln. Demgegenüber handelt es sich bei dem zweitgenannten Gebäudeelement um ein Bauteil der äußeren Gebäudeaußenhaut, wie beispielsweise eine Dacheindeckungsplatte oder eine Fassadenplatte.

Bei der vorliegenden Erfindung geht es im wesentlichen um die Nutzung der Sonnenenergie im Bereich der Gebäudehülle eines Gebäudes.

Bekannt ist im Bereich von Gebäuden der Einsatz der Solarthermie sowie der Photovoltaik zur Umwandlung von sichtbarem Licht in Wärmeenergie bzw. elektrische Energie.

Unter Solarthermie versteht man die Umwandlung der Sonnenenergie in nutzbare Wärmeenergie. Dies geschieht üblicherweise durch Nutzung der einfallenden Sonnenenergie über sogenannte Sonnenkollektoren.

Unter Photovoltaik versteht man die direkte Umwandlung von Strahlungsenergie, vornehmlich Sonnenenergie, in elektrische Energie. Die Energiewandlung findet dabei mit Hilfe von Solarzellen, die zu sogenannten Solarmodulen verbunden werden, in Photovoltaikanlagen statt. Die erzeugte Elektrizität kann dann entweder vor Ort genutzt oder in Stromnetze eingespeist werden.

Der Einsatz der Solarthermie und der Photovoltaik im Bereich von Gebäuden hat allerdings verschiedene Nachteile. Ein wesentlicher Nachteil besteht sowohl bei Solarthermie- als auch bei Photovoltaikanlagen darin, daß üblicherweise eine entsprechende Anordnung auf der Gebäudeaußenhaut, häufig auf dem Dach oder einer stark sonnenbeschienenen Fassade notwendig ist. Diese außenseitige Anordnung auf dem Dach oder der Fassade wird häufig als optisch-ästhetische Beeinträchtigung des Gebäudes empfunden, so daß von einer Nutzung dieser Anlagen zum Teil schon aus diesem Grunde abgesehen wird. Darüber hinaus ist es so, daß die Anlagentechnik beider Systeme zum Teil relativ aufwendig ist, was mit nicht unerheblichen Kosten verbunden ist, so daß viele Nutzer auch aus Kostengründen von dem Einsatz solcher Anlagen abgehalten werden. Ein weiterer wesentlicher Nachteil, der sich durch die Notwendigkeit der außenseitigen Anordnung dieser Anlagen ergibt, besteht darin, daß die betreffenden Anlagen äußeren Umwelteinflüssen direkt ausgesetzt sind. Gerade bei Stürmen, Hagel o. dgl. kann es zu Beschädigungen der Anlagen oder zumindest von Anlagenteilen kommen.

Aus der US 2005/0279400 A1 sind bereits Dacheindeckungselemente, insbesondere in Form von Dachziegeln o. dgl. bekannt, die auf der Außenseite eine photovoltaische Zelle bzw. Solarzelle aufweisen. Die Dacheindeckungselemente sind mit seitlichen Anschlüssen zur elektrischen Verbindung mit benachbarten Eindeckungsplatten versehen. Derartige Aufbauten sind sehr aufwendig und dementsprechend kostenträchtig.

Aus der DE 100 02 986 A1 gehen flache Dacheindeckungen aus lichtdurchlässigem Material mit darunter angeordneten Photovoltaik-Einheiten hervor. Dabei werden herkömmliche Solarzellen unter den lichtdurchlässigen Dacheindeckungen angeordnet, um sichtbares Licht in Strom umzuwandeln. Problematisch ist, daß hier spezielle lichtdurchlässige Dacheindeckungen eingesetzt werden müssen. Des weiteren ist der Wirkungsgrad gegenüber üblichen Solarzellen auf der Außenseite von Dacheindeckungen wesentlich geringer. Problematisch ist in diesem Zusammenhang auch, wenn sich auf die lichtdurchlässigen Dacheindeckungen Laub legt oder diese Dacheindeckungen anderweitig verschmutzen. Dies führt letztlich zu einer noch weiteren Wirkungsgradverringerung.

Aus der WO 03/105240 A1 ist ein thermisches Verbundsystem bekannt, dass aus einem Photovoltaiksystem und einem thermoelektrischen System besteht. Das thermische Verbundsystem kann in einer Tragkonstruktion einer Gebäudeaußenhaut vorgesehen sein, um dort zur Erhöhung der Energieeffizienz eines Gebäudes eine thermische Gebäudehülle bereitzustellen. Wird die Tragkonstruktion als ein Bauteil für ein Gebäude verwendet, befindet sich das Photovoltaiksystem außenseitig an einem Gebäude, um Sonnenlicht aufzunehmen und elektrische Energie zu erzeugen. Die erzeugte Energie wird dem thermoelektrischen Verbundsystem zur Verfügung gestellt, damit das thermoelektrische Verbundsystem Wärme und auch Kälte erzeugen kann. Im Falle der Wärmeerzeugung wird erzeugte Wärme über Wärmeableiter in eine Wärmespeicherschicht geleitet. Dieser konstruktive Aufbau ist aufwendig und dementsprechend mit hohen Kosten verbunden.

Aus der EP 1 818 992 A1 ist ein Dachelement zur Wärmeisolierung bekannt, wobei das Dachelement eine Mehrzahl von thermoelektrischen Elementen zur Erzeugung von elektrischer Energie unter Nutzung von Wärmestrahlung aufweist. Die thermoelektrischen Elemente bilden mit einer oberen und unteren Abdeckplatte ein Dachelement zur Wärmeisolierung mit integrierter Stromerzeugung unmittelbar in einer äußeren Gebäudehaut.

Aus dem Artikel von MANEEWAN S ET AL: "Experimental investigation on generated power of thermoelectric roof solar collector" THERMOELECTRICS, 2003 TWENTY-SECOND INTERNATIONAL CONFERENCE ON - ICT LA GRANDE MOTTE, FRANCE AUG. 17-21, 2003, PISCATAWAY, NJ, USA,IEEE, 17.AUGUST 2003 (2003-08-17), Seiten 574-577 XP010697379 ISBN: 978-0-7803-8301-2, ist ein thermoelektrischer Dachsonnenkollektor bekannt. Das System besteht aus einer transparenten Acrylschicht, einer Luftschicht, einer durch Wärmestrahlung zu erhitzenden Kupferplatte, thermoelektrischen Modulen zur Erzeugung von Strom durch die Wärmestrahlung und einem Wärmeableiter. Der generierte Strom kann zum Betrieb eines Ventilators zur Kühlung eines Gebäudes genutzt werden, wobei das System im Dach eines Gebäudes in einer Gebäudeaußenhaut, angeordnet ist.

Aus der DE 199 46 806 A1 ist ein Verfahren und eine Einrichtung zur Erzeugung elektrischer Energie aus thermischer Energie nach dem Seebeck-Effekt bekannt. Zur Erzeugung von thermischer Energie kann ein Seebeck-Modul vorgesehen sein, um die natürlichen Temperatur-, Wind- und Klimaunterschiede in der Umwelt und/oder Abwärmeverluste technischer Anlagung zur Stromerzeugung zu verwenden. Insbesondere können Seebeck-Module bzw. Energie-Module in der Gebäudeaußenhaut eines Gebäudes bzw. einer Fassade oder in Dachziegeln für ein Dach eines Gebäudes angeordnet sein.

Aus der JP 2004 204546 A ist bekannt, thermoelektrische Elemente in einer Gebäudeaußenhaut, wie einem Dachelement, anzuordnen. Direkt unterhalb einer äußeren Dachabdeckung können hierbei eine wasserdichte Schicht und ein Wärmespeichermaterial vorgesehen sein, sodass direkt unter der Wärmespeichermaterialschicht thermoelektrische Elemente zur Aufnahme von Wärme zur Erzeugung eines Stroms angeordnet sind.

Aus der JP 2001 132193 A ist ein Peltier-Modul in einem Gebäudeteil zur Wärmeisolation bekannt. Dabei erzeugt das Peltier-Modul Wärme oder Kälte.

Aus dem Artikel von KHIRE R A ET AL: "Design of thermoelectic heat pump unit for active Building envelope systems", INTERNATIONAL JOURNAL OF HEAT AND MASS TRANSFER, PERGAMON PRESS, GB LNKD-DOI:10.1016/J.IJHEATMASSTRANSFER.2005.04.028, Bd. 48, Nr. 19-20, 1. September 2005 (2005-09-01), Seiten 4028-4040, XP004984769 ISSN: 0017-9310, ist ein aktives Gebäudehüllensystem bekannt. Das Gebäudehüllensystem enthält eine Reihe von thermoelektrischen Einheiten zur Kühlung oder zur Erwärmung von Gebäuden. Nachteilig ist hierbei, dass die Anordnung des Systems vorsieht, dass in einer Gebäudeaußenhaut den thermoelektrischen Einheiten ein Photovoltaiksystem vorgeschaltet sein muss, um Strom zu erzeugen.

Der vorliegenden Erfindung liegt nun die Aufgabe zugrunde, Gebäudeelemente, Gebäudehüllen und Gebäude zur Verfügung zu stellen, wobei auf verhältnismäßig einfache und kostengünstige Weise eine Stromerzeugung erfolgen kann und/oder wobei herkömmliche und/oder nur mit geringen Modifikationen zu versehene Gebäudegrundelemente verwendet werden können.

Die vorgenannte Aufgabe ist bei einem Gebäudeelement einer eine Gebäudeaußenhaut aufweisenden Gebäudehülle eines Gebäudes der eingangs genannten Art dadurch gelöst, dass der Generator auf der der Gebäudeaußenhaut zugewandten Außenseite des Gebäudegrundelements angeordnet ist. Diese Erfindungsalternative sieht also vor, an Gebäudegrundelementen, die in der Gebäudehülle hinter der Gebäudeaußenhaut angeordnet sind, wenigstens einen thermoelektrischen Generator zur Umwandlung von Wärmestrahlung in Strom anzuordnen. Bei den Gebäudegrundelementen kann es sich um die Tragkonstruktion oder um Teile davon, Gebäudeplatten, Dämmplatten oder auch Unterspann- oder Unterdeckbahnen handeln. An diesen ist wenigstens ein Generator befestigt, beispielsweise verklebt, oder darin integriert. Dabei versteht es sich dann, daß das Gebäudeelement entsprechende Anschlüsse aufweist, um den thermoelektrischen Generator entweder mit weiteren Generatoren des gleichen oder anderer Gebäudeelemente zu verbinden oder aber, um den vom Generator erzeugten Strom abzuführen.

Bei dem thermoelektrischen Generator handelt es sich um einen elektrothermischen Wandler, der basierend auf dem Seebeck-Effekt bei Temperaturdifferenz einen Stromfluß erzeugt. Thermoelektrische Generatoren und Peltier-Anordnungen sind seit langem bekannt. p- und n-dotierte Halbleiter, deren thermische Kontaktflächen unterschiedliche Temperaturen aufweisen, transportieren elektrische Ladungen durch einen äußeren Stromkreis. Durch diese thermoelektrischen Generatoren kann an einem Verbraucher im Stromkreis elektrische Arbeit verrichtet werden. Peltier-Anordnungen kehren den zuvor beschriebenen Prozeß um, sind jedoch identisch aufgebaut wie thermoelektrische Generatoren.

Gegenwärtig werden thermoelektrische Generatoren in verschiedenen Bereichen, wo große Wärmemengen und hohe Temperaturen anfallen, eingesetzt. Die Vorteile von thermoelektrischen Generatoren liegen in ihrer hohen Zuverlässigkeit. Sie arbeiten unabhängig von atmosphärischen Bedingungen wie Luftfeuchte. Es erfolgt kein störungsanfälliger Stofftransport, sondern nur ein Ladungstransport.

Die für thermoelektrische Generatoren eingesetzten Materialien werden üblicherweise anhand der Gütezahl ZT bewertet, die vom Seebeck-Koeffizienten, der elektrischen Leitfähigkeit, der Wärmeleitfähigkeit und der Temperatur abhängt. Die in der Gütezahl enthaltenen Materialgrößen hängen vor allem von der Ladungsträgerkonzentration des jeweiligen Materials ab, wobei Halbleiter mit schmaler Bandlücke die höchsten ZT-Werte im Bereich der Raumtemperatur erreichen. Von daher sind auch im Zusammenhang mit der vorliegenden Erfindung entsprechende Halbleitermaterialien mit schmaler Bandlücke zu bevorzugen. Die Erhöhung der thermoelektrischen Gütezahl ist immer als Optimierung des gesamten Parametersatzes zu verstehen und läßt sich nicht durch eine Maximierung oder Minimierung von nur einer der enthaltenen Größen erreichen.

Die derzeit kommerziell erhältlichen thermoelektrischen Bauelemente erreichen Gütezahlen im Bereich von etwa ZT = 1. Durch den Einsatz von nanostrukturierten Materialien lassen sich ZT-Werte zwischen 1 bis 3 erreichen.

Gute ZT-Werte werden in der Regel dann erreicht, wenn das bei dem thermoelektrischen Generator eingesetzte thermoelektrische Material ein Mischoxid aufweist, das die Elemente Titan, Sauerstoff, Schwefel und Me mit Me = Kalzium, Strontium und/oder Barium enthält. Hierdurch sind Wirkungsgrade zwischen 3 bis 5 % möglich. Gleiche Wirkungsgrade ergeben sich beim Einsatz von Halbleitermaterialien aus Bi₂Te₃, PbTe, Si, Ge, BiSb oder FeSi₂.

Zur Erzielung eines hohen thermoelektrischen Wirkungsgrades ist bei einer bevorzugten Ausführungsform vorgesehen, daß der Generator auf der der Gebäudeaußenhaut zugewandten Außenseite des Gebäudegrundelements angeordnet ist. Der Generator weist damit im eingebauten Zustand mit seiner die Wärmestrahlung aufnehmenden Kontaktseite in Richtung auf die Gebäudeaußenhaut und ist bevorzugt nur gering von der Gebäudeaußenhaut beabstandet, um einen großen Anteil an Wärmestrahlung aufnehmen zu können.

Anders als bei dem erfindungsgemäßen innenliegenden Gebäudeelement ist es bei dem außenliegenden Gebäudeelement, bei dem es sich beispielsweise um eine Dacheindeckungsplatte oder eine Fassadenplatte handelt, so, daß der thermoelektrische Generator auf der Innenseite des Außenhautelements angeordnet ist. Der Generator nimmt dann die Wärme, insbesondere durch Wärmeleitung des Außenhautelements, direkt auf.

Bei beiden erfindungsgemäßen Alternativen ist es aber jeweils so, daß sich der thermoelektrische Generator bzw. die Anordnung zur Erzeugung des elektrischen Stroms nicht auf der Außenseite der Außenhaut der Gebäudehülle des Gebäudes befindet, so daß der optisch-ästhetische Eindruck des Gebäudes nicht beeinträchtigt wird und die Anordnung im übrigen auch nicht den Umwelteinflüssen und damit der Gefahr von Beschädigungen bei Stürmen, Hagel o. dgl. ausgesetzt ist.

Bei einer bevorzugten Ausführungsform der Erfindung sind Generatoren sowohl an den Gebäudeelementen der Gebäudeaußenhaut als auch an den innenliegenden Gebäudeelementen vorgesehen. Auf diese Weise kann problemlos eine Erhöhung der Anzahl der thermoelektrischen Generatoren pro Flächeneinheit erzielt werden.

Insbesondere wenn die thermoelektrischen Generatoren zum Einsatz in Verbindung mit Unterspann- oder Unterdeckbahnen vorgesehen sind, bietet es sich an, die Generatoren flexibel oder folienartig auszubilden. Auf diese Weise wird die Funktion und Handhabung der betreffenden Bahnen durch die oberseitig an den Bahnen vorgesehenen Generatoren nicht beeinträchtigt.

Im Hinblick auf die auftretenden Temperaturen im Bereich der Gebäudeaußenhaut ist der thermoelektrische Generator, insbesondere was die Materialauswahl der Halbleitermaterialien angeht, derart ausgebildet, daß der Generator zur Umwandlung von Infrarot-Strahlung im Wellenlängenbereich zwischen 2 bis 20 µm, vorzugsweise zwischen 6 und 13 µm ausgebildet und optimiert ist. Dies bedeutet, daß im vorgenannten Intervall das Absorptionsmaximum liegt. Dabei versteht es sich, daß jeder einzelne Wert innerhalb der vorgenannten Bereichsgrenzen möglich ist. Bevorzugt liegt das Absorptionsmaximum bei einer Wellenlänge zwischen 8 und 10 µm.

Zur Erhöhung der Effizienz ist bei der Gebäudeaußenhaut der erfindungsgemäßen Gebäudehülle vorgesehen, daß wenigstens ein äußeres Gebäudeelement bzw. ein Außenhautelement außenseitig zumindest bereichsweise mit einer Beschichtung zur Erhöhung der Erwärmung vorgesehen ist. Bei der vorgenannten Beschichtung handelt es sich um eine Absorberschicht, die bevorzugt einen hohen Absorptionsgrad (niedrige Reflexion) im Bereich des sichtbaren Lichts und/oder eine niedrige Emission (hohe Reflexion) im Bereich der Wärmestrahlung aufweist. Bevorzugt sollte die Beschichtung eine hohe Absorption im Bereich des sichtbaren Lichts von mehr als 80 %, bevorzugt mehr als 90 % und insbesondere im Bereich zwischen 92 und 98 % aufweisen. Die Emission im Bereich der Wärmestrahlung sollte zwischen 2 bis 10 % und insbesondere zwischen 3 bis 7 % liegen. So können beispielsweise bei einer 95 %-igen Absorption des sichtbaren Lichts und einer 5 %-igen Emission im Bereich der Wärmestrahlung etwa 90 % der einfallenden Sonnenenergie in nutzbare Wärme umgewandelt werden.

Bevorzugt ist die vorgenannte Beschichtung aus mehreren Funktionsschichten aufgebaut. Als Trägermaterial kann ein Metallsubstrat mit guter Reflexion und Wärmeleitung dienen. Das Trägermaterial wird dann auf die Außenseite des betreffenden Gebäudeelements aufgebracht oder kann dieses bilden. Des weiteren kann eine dünne Titankarbitverbindung oder sonstige Verbindung als Haftvermittlungsschicht und Diffusionssperre dienen. Auf dem Trägermaterial bzw. der optionalen Haftvermittlungsschicht ist als eigentliche Funktionsschicht die Absorberschicht vorgesehen. Diese besteht vorzugsweise aus einer Titanverbindung mit Sauerstoff und Stickstoff. Bevorzugt kommen dabei TiN, TiO und TiO₂ zum Einsatz. Auf der Absorberschicht kann sich abschließend eine Antireflexions- und/oder Schutzschicht befinden, die grundsätzlich aus einem Quarzglas, aber auch aus einem Kunststoffinaterial bestehen kann. Durch die Minimierung der Oberflächenreflexion wird die Absorption der Sonnenstrahlung noch weiter optimiert.

Es versteht sich, daß es im Zusammenhang mit der vorliegenden Erfindung ausreichend ist, lediglich die Absorberschicht auf dem Außenhautelement vorzusehen, wobei das Außenhautelement selbst als Träger dienen kann. Zur besseren Verbindung zwischen der Absorberschicht und dem Außenhautelement kann ergänzend noch die Haftvermittlungsschicht und/oder außenseitig die Schutzschicht vorgesehen sein.

Der vorgenannten Beschichtung kommt deshalb eine nicht unerhebliche Bedeutung zu, da nach dem Stefan-Boltzmannschen-Gesetz die abgegebene Strahlungsenergie proportional zur vierten Potenz der Temperatur ist. Je höher also die Temperatur ist, um so höher ist der Energiegewinn.

Im Zusammenhang mit der erfindungsgemäßen Gebäudehülle kann es sich im übrigen anbieten, dem Gebäudeelement innenseitig eine Kühleinrichtung zuzuordnen. Letztlich geht es darum, die geringer temperierte Kontaktfläche des Generators zu kühlen, um eine möglichst große Temperaturdifferenz zwischen den Generatorflächen zu erzielen, so daß sich letztlich ein entsprechend hoher Strom ergibt.

Im übrigen ist es vorteilhaft, daß das den thermoelektrischen Generator aufweisende Gebäudeelement in überwiegend sonnenbeschienenen Bereichen der Gebäudehülle, d. h. insbesondere in Bereichen, die nach Osten, Süden und/oder Westen ausgerichtet sind, vorgesehen ist. Besonders bevorzugt ist die Verwendung erfindungsgemäßer Gebäudeelemente in den Bereichen des Gebäudes mit einer Süd-, Südwest- oder Südostausrichtung.

Im Zusammenhang mit dem erfindungsgemäßen Gebäude ist im übrigen vorgesehen, daß der Generator mit wenigstens einem Verbraucher im Gebäude gekoppelt ist. Da von dem Generator ein Gleichstrom mit vergleichsweise kleinen Spannungen erzeugt wird, bietet es sich an, daß der Generator mit einem Akkumulator als Energiespeicher und/oder mit einem Wechselrichter gekoppelt ist, so daß der erzeugte Strom nicht nur von einem Wechselstrom-Verbraucher vor Ort genutzt, sondern auch in das öffentliche Stromnetz eingespeist werden kann. Dabei dient der Energiespeicher letztlich als Puffer, um kontinuierlich Energie zur Verfügung stellen zu können.

Schließlich betrifft die vorliegende Erfindung die Verwendung von thermoelektrischen Generatoren zur Umwandlung von Wärme, insbesondere Wärmestrahlung, in Strom im Bereich von Gebäuden, wobei die Generatoren unter oder hinter einer Gebäudeaußenhaut eines Gebäudes angeordnet werden und von der Gebäudeaußenhaut abgegebene und/oder durchgelassene Wärme, insbesondere Infrarotstrahlung, in Strom umwandeln.

Weitere Aspekte, Vorteile, Eigenschaften und Merkmale der vorliegenden Erfindung ergeben sich aus den Ansprüchen und der nachfolgenden Beschreibung einer bevorzugten Ausführungsform anhand der Zeichnung. Es zeigt
- Fig. 1: eine schematische Darstellung eines Gebäudes mit einer Gebäudehülle,
- Fig. 2: eine schematische Darstellung eines Teils einer Gebäudehülle,
- Fig. 3: eine schematische Darstellung eines nicht erfindungsgemäßen Gebäudeelementes und
- Fig. 4: eine schematische Darstellung eines thermoelektrischen Generators zur Verwendung bei einem Gebäudeelement.

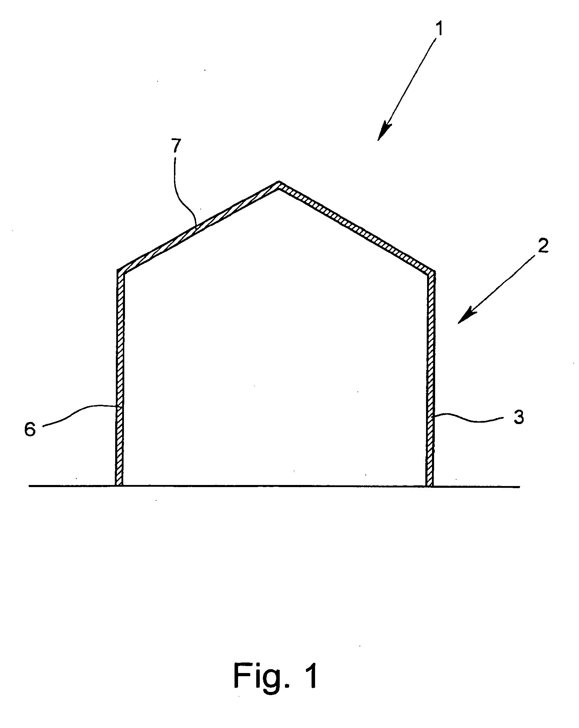

In Fig. 1 ist schematisch ein Gebäude 1 dargestellt. Das Gebäude 1 weist eine Gebäudehülle 2 auf, die nach außen hin von einer Gebäudeaußenhaut 3 begrenzt ist oder diese bildet. Sowohl die Gebäudehülle 2 als auch die Gebäudeaußenhaut 3 weisen Gebäudeelemente 4, 5 auf, wobei die Gebäudeelemente 4 der Gebäudehülle 2 hinter der Gebäudeaußenhaut 3 angeordnet sind, während die Gebäudeelemente 5 als Teil der Gebäudeaußenhaut 3 außenseitig angeordnet sind. Damit bilden die Außenseiten der Gebäudeelemente 5 die Außenseite der Gebäudeaußenhaut 3.

Im dargestellten Ausführungsbeispiel weist die Gebäudehülle 2 des Gebäudes 1 eine Fassade 6 und ein Dach 7 auf. Sowohl die Fassade 6 als auch das Dach 7 weisen einzelne Gebäudeelemente 4, 5 auf, worauf nachfolgend noch näher eingegangen wird.

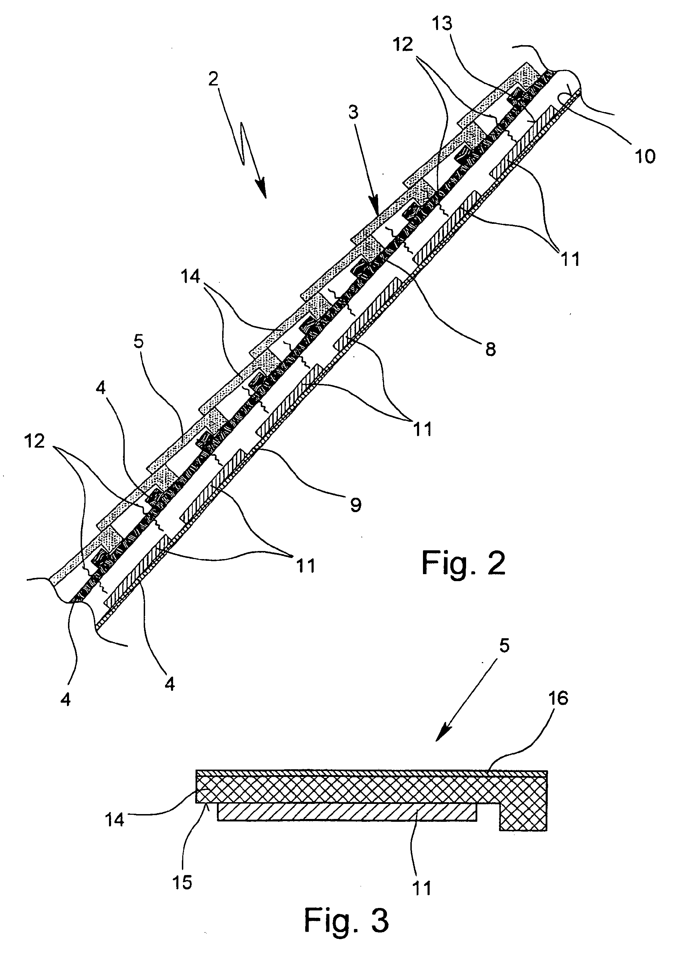

In Fig. 2 ist ein Teil der Gebäudehülle 3 dargestellt. Im einzelnen geht es um einen Teil des Daches 7. Die Gebäudehülle 2 weist vorliegend ein Gebäudeaußenhaut 3 eine Vielzahl von äußeren Gebäudeelementen 5 auf, die letztlich Außenhautelemente bilden. Anders als bei der noch zu beschreibenden Ausführungsform gemäß Fig. 3 sind die äußeren Gebäudeelemente 5 und die Außenhautelemente bei der Ausführungsform gemäß Fig. 2 identisch. Hierbei handelt es sich bei dem dargestellten Ausführungsbeispiel um bekannte Dacheindeckungselemente. Unter bzw. hinter der Gebäudeaußenhaut 3, also in Richtung zum Gebäudeinneren, sind innenliegende Gebäudeelemente 4 als Teile der Gebäudehülle 2 vorgesehen. Bei den einzelnen Gebäudeelementen 4, die, sofern sie keine Modifikation in Richtung auf die vorliegende Erfindung darstellen, bekannten Gebäudegrundelementen entsprechen, handelt sich vorliegend um eine Traglattung 8, auf die die Dacheindeckungselemente aufgelegt sind, sowie eine Unterspannbahn 9, die unterhalb der Traglattung 8 angeordnet ist.

Hinzuweisen ist darauf, daß in Fig. 2 lediglich eine beispielhafte Ausführungsform dargestellt ist. Es versteht sich, daß die Gebäudehülle 2 nicht notwendigerweise eine Unterspannbahn 9 aufweisen muß. Darüber hinaus können, was hier nicht dargestellt ist, auch Dämmplatten oder sonstige Bauplatten Teil der Gebäudehülle sein. Die vorgenannten Bauteile stellen dann gleichfalls Gebäudeelemente 4 bzw. Gebäudegrundelemente im Sinne der vorliegenden Erfindung dar.

Die vorstehenden Ausführungen hinsichtlich der Gebäudeelemente 4, 5 gelten im übrigen auch für den Teil der Fassade. Dabei wird dann die Gebäudeaußenhaut von außenliegenden Fassadenplatten als äußere Gebäudeelemente oder Außenhautelemente gebildet, während die hinter den Fassadenplatten angeordneten Elemente die innenliegenden Gebäudeelemente bzw. Gebäudegrundelemente bilden.

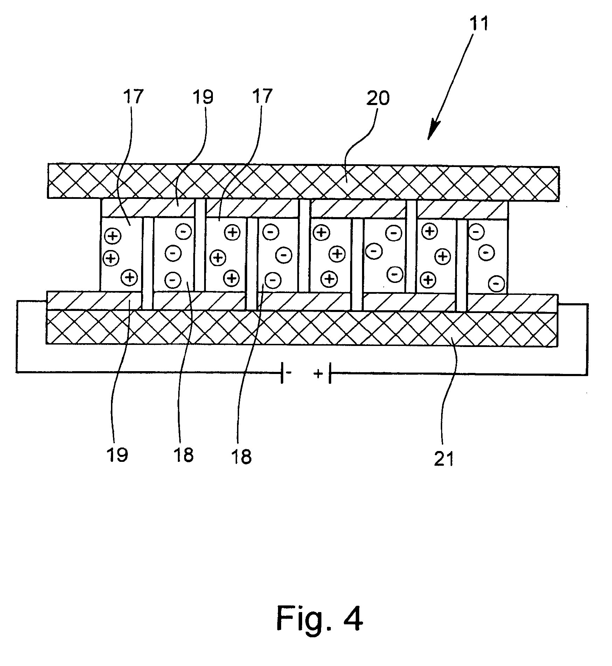

Bei der in Fig. 2 dargestellten Ausführungsform ist es nun so, daß auf der Außen- bzw. Oberseite 10 von Gebäudeelementen 4, hier der Unterspannbahn 9, eine Mehrzahl von thermoelektrischen Generatoren 11 vorgesehen ist. Grundsätzlich ist es auch möglich, statt einer Vielzahl kleinerer Generatoren 11 eine geringere Anzahl von von der Fläche her größere Generatoren 11 vorzusehen. Auf einen bevorzugten Aufbau der thermoelektrischen Generatoren 11 wird unter Bezugnahme auf Fig. 4 später eingegangen. Im vorliegenden Fall dienen die thermoelektrischen Generatoren 11 zur Umwandlung von Wärmestrahlung 12, die sich aus der Sonnenbestrahlung der Gebäudeaußenhaut 3 ergibt bzw. von die Außenhülle 3 bildenden Gebäudeelementen 5 abgegeben wird, in elektrischen Strom.

Hinzuweisen ist darauf, daß statt auf der Oberseite 10 der Unterspannbahn 9 thermoelektrische Generatoren auch auf der den Gebäudeelementen 5 zugewandten Oberseiten der Dachlattung 8 vorgesehen sein könnten. Im übrigen könnten bei Nicht-Realisierung der Unterspannbahn 9 die Generatoren 11 auch auf weiteren innenliegenden Gebäudeelementen 4 vorgesehen sein.

Im dargestellten Ausführungsbeispiel sind die Generatoren 11 mit der Oberseite 10 der Unterspannbahn 9 vorzugsweise verklebt. Nicht dargestellt ist, daß die einzelnen Generatoren 11 elektrisch vorzugsweise an einen nicht dargestellten Akkumulator und/oder Wandler angeschlossen sind.

Es ist im übrigen darauf hinzuweisen, daß die Generatoren 11 grundsätzlich auch in die Unterspannbahn 9 einlaminiert oder in anderer Weise an der Unterspannbahn 9 befestigt oder in diese integriert sein können. Darüber hinaus kann, was ebenfalls nicht dargestellt ist, die Unterspannbahn 9 wärme- oder infrarotstrahlungsreflektierend ausgebildet sein, so daß der überwiegende Teil der Wärmestrahlung auf die Generatoren 11 übergeht. Der Abstand der Oberseite 13 der Generatoren 11 zur die Wärmestrahlung 12 abgegebenen Unterseite der Gebäudeelemente 5 sollte nur wenige Zentimeter, vorzugsweise weniger als 5 cm betragen.

In der nicht erfindungsgemäßen Fig. 3 ist ein Dachziegel als äußeres Gebäudeelement 5 dargestellt. Das Gebäudeelement 5 weist ein Außenhautelement 14 als Grundkörper auf. Dabei ist es so, daß an der Innen- oder Unterseite 15 des Außenhautelements 14 ein thermoelektrischer Generator 11 vorgesehen ist. Dieser Generator 11 wandelt die durch Wärmeleitung durch das Außenhautelement 14 übertragene Wärmeenergie in elektrischen Strom um. Darüber hinaus weist das Gebäudeelement 5 auf seiner Außenseite vorzugsweise eine Absorptionsschicht bzw. Beschichtung 16 auf. Die Beschichtung 16, die beispielsweise aus einer Titanoxinitritverbindung bestehen kann, weist einen solaren Absorptionsgrad von 90% ± 8% und/oder einen thermischen Emissionsgrad von 10% ± 8% auf. Letztlich sorgt die Absorptionsschicht dafür, daß nur ein geringer Anteil der Sonnenstrahlung reflektiert und nur ein geringer Teil der Wärmestrahlung nach außen abgegeben wird. Der überwiegende Teil der Sonnenenergie wird in Form von Wärme in Richtung auf die thermoelektrischen Generatoren 11 abgegeben.

Es versteht sich, daß die Beschichtung 16 grundsätzlich nicht nur in Kombination mit thermoelektrischen Generatoren 11 an den Gebäudeelementen 5 vorgesehen sein muß. So ist es ohne weiteres möglich, auch nur außenseitig an den Gebäudeelementen 5 die Beschichtung 16 vorzusehen, ohne daß unterseitig Generatoren 11 vorgesehen sein müssen. Auch können die Generatoren 11 vorgesehen sein, ohne daß die Beschichtung vorgesehen ist.

Hinzuweisen ist im übrigen darauf, daß die Gebäudeelemente 4, 5 mit den Generatoren 11 vorgefertigte Baueinheiten bilden können, die dann als vollständige Baueinheit an der Baustelle zusammen mit dem betreffenden Gebäudegrundelement verlegt werden. In diesem Falle ist dann nur noch eine elektrische Verbindung der einzelnen Generatoren 11 bzw. der elektrische Anschluß erforderlich. Es ist aber auch möglich, auf an sich bekannte Außenhautelemente bzw. Gebäudegrundelemente, die jeweiligen Generatoren 11 erst auf der Baustelle anzubringen. So ist es beispielsweise möglich, nach Verlegung der Unterspannbahn 9 auf die Oberseite 10 der Unterspannbahn 9 die Generatoren 11 aufzubringen und diese elektrisch anschließend anzuschließen. Das Aufbringen könnte dann in einfacher Weise durch zuvor erwähnte Verklebung erfolgen. Gleiches gilt für die unterseitige Anordnung der Generatoren 11 auf der Unterseite der Dachziegel.

Nicht dargestellt ist im übrigen, daß unterhalb der Generatoren 11, also in Richtung zum Gebäudeinneren hin, eine Kühlung oder Wärmesenke vorgesehen sein kann. Auf den Effekt der Kühlung wird nachfolgend in Verbindung mit Fig. 4 noch näher eingegangen.

In Fig. 4 ist schematisch ein bevorzugter Aufbau eines thermoelektrischen Generators 11 dargestellt. Der Generator 11 besteht aus wenigstens zwei, vorliegend aus acht Quadern 17, 18 aus p- und n-dotiertem Halbleitermaterial, die abwechselnd oben und unten durch Metallbrücken 19 miteinander verbunden sind. Die Metallbrücken 19 bilden zugleich die thermischen Kontaktflächen und sind durch eine oberseitige Platte 20 und eine unterseitige Platte 21 isoliert. Die Anordnung der Quader 17 ,18 ist so, daß p-dotierte Quader 17 und n-dotierte Quader 18 nacheinander so elektrisch miteinander verbunden sind, daß sie in Reihe geschaltet sind. Durch Herstellen einer Temperaturdifferenz zwischen den Platten 20, 21 bzw. den Kontaktflächen wird ein elektrischer Strom erzeugt. Je größer die Temperaturdifferenz ist, um so größer ist der erzeugte Strom. Ist beispielsweise die der Platte 21 zugeordneten Kontaktfläche mit ihrer Oberseite zur Aufnahme der Wärme bzw. Wärmestrahlung vorgesehen, während die der unteren Platte 21 zugewandte Kontaktfläche zum Gebäudeinneren hin gewandt ist und eine geringere Temperatur aufweist, ergibt sich ein elektrischer Strom. Wird die auf die Platte 20 wirkende Temperatur erhöht, beispielsweise durch Verwendung der zuvor genannten Beschichtung auf Platte 20 oder Gebäudeelement 5 und wird darüber hinaus die Platte 21 unterseitig gekühlt, ergibt sich eine vergrößerte Temperaturdifferenz und damit ein größerer Strom. In diesem Zusammenhang kann es sich anbieten, die Platte 21 als Kühlkörper auszubilden. Zweckmäßigerweise könnte die Unterspannbahn 9 dabei gut wärmeleitend zur Kühlung ausgebildet sein.

Im dargestellten Ausführungsbeispiel gemäß Fig. 4 befindet sich der Generator 11 in liegender Einbaustellung. Letztlich ist die Lage des Generators 11 bzw. der Platten 20, 21 der Lage des betreffenden Gebäudeelements 4, 5 in der Einbaustellung angepaßt. Bei einer Dachanordung ist der Generator 11 daher schräg angeordnet, während er beispielsweise bei einer Fassadenanordnung in senkrechter Stellung angeordnet ist, so daß die Platten 20, 21 stehend angeordnet sind.

### Bezugszeichenliste

- 1: Gebäude
- 2: Gebäudehülle
- 3: Gebäudeaußenhaut
- 4: Gebäudeteil
- 5: Gebäudeteil
- 6: Fassade
- 7: Dach
- 8: Traglattung
- 9: Unterspannbahn
- 10: Oberseite
- 11: Generator
- 12: Wärmestrahlung
- 13: Oberseite
- 14: Außenhautelement
- 15: Unterseite
- 16: Beschichtung
- 17: Quader
- 18: Quader
- 19: Brücke
- 20: Platte
- 21: Platte

## Patentansprüche

1. Gebäudeelement (4) einer eine Gebäudeaußenhaut (3) aufweisenden oder bildenden Gebäudehülle (2) eines Gebäudes (1), mit einem unter oder hinter der Gebäudeaußenhaut (3) anzuordnenden Gebäudegrundelement und wenigstens einem dem Gebäudegrundelement zugeordneten thermoelektrischen Generator (11) zur Umwandlung von Wärme, insbesondere Wärmestrahlung, in Strom, **dadurch gekennzeichnet, dass** der Generator (11) auf der der Gebäudeaußenhaut (3) zugewandten Außenseite des Gebäudegrundelements angeordnet ist.

2. Gebäudeelement nach Anspruch 1, **dadurch gekennzeichnet, daß** der Generator (11) an einem Tragkonstruktionsmittel, einer Gebäudeplatte, einer Dämmplatte oder einer Unterspann- oder Unterdeckbahn (9) als Gebäudegrundelement vorgesehen ist.

3. Gebäudeelement nach Anspruch 1 oder 2, **dadurch gekennzeichnet, daß** der Generator (11) mit dem Gebäudegrundelement oder dem Außenhautelement (14) fest verbunden, insbesondere verklebt, oder darin integriert ist.

4. Gebäudeelement nach einem der vorhergehenden Ansprüche, **dadurch gekennzeichnet, daß** der Generator (11) flexibel oder folienartig ausgebildet ist.

5. Gebäudeelement nach einem der vorhergehenden Ansprüche, **dadurch gekennzeichnet, daß** der Generator (11) zur Umwandlung von Infrarotstrahlung, insbesondere mit einer Wellenlänge im Bereich zwischen 2 und 20 µm, vorzugsweise zwischen 7 und 13 µm und insbesondere zwischen 8 und 10 µm ausgebildet und optimiert ist.

6. Gebäudeelement nach einem der vorhergehenden Ansprüche, **dadurch gekennzeichnet, daß** zusätzlich wenigstens ein Photovoltaik- und/oder Solarthermie-Mittel vorgesehen ist.

7. Gebäudehülle (2) eines Gebäudes (1) mit wenigstens einem Gebäudeelement (4, 5) nach einem der vorgehenden Ansprüche und einer äußeren Gebäudeaußenhaut (3), wobei das Gebäudeelement (4, 5) wenigstens einen thermoelektrischen Generator (11) zur Umwandlung von Wärme, insbesondere Wärmestrahlung, in Strom aufweist.

8. Gebäudehülle nach Anspruch 7, **dadurch gekennzeichnet, daß** dem Generator (11) innenseitig eine Kühleinrichtung zugeordnet ist.

9. Gebäudehülle nach Anspruch 7 oder 8, **dadurch gekennzeichnet, daß** das Gebäudeelement (4, 5) in überwiegend sonnenbeschienenen Bereichen der Gebäudehülle (2), insbesondere in nach Osten, Süden und/oder Westen hin ausgerichteten Bereichen der Gebäudehülle (2) vorgesehen ist.

10. Gebäudehülle nach einem der Ansprüche 7 bis 9, **dadurch gekennzeichnet, daß** die Gebäudeaußenhaut (3) wenigstens ein transparentes Außenhautelement (14) aufweist.

11. Gebäudehülle nach einem der Ansprüche 7 bis 10, **dadurch gekennzeichnet, daß** die Gebäudeaußenhaut (3) außenseitig zumindest bereichsweise mit einer Beschichtung (16) zur Erhöhung der Erwärmung vorgesehen ist.

12. Gebäude (1) mit einer Gebäudehülle (2) nach einem der Ansprüche 7 bis 11.

13. Gebäude nach Anspruch 12, **dadurch gekennzeichnet, daß** der Generator (11) mit wenigstens einem Verbraucher im Gebäude (1) gekoppelt ist.

14. Gebäude nach Anspruch 12 oder 13, **dadurch gekennzeichnet, daß** der Generator (11) mit einem Wechselrichter gekoppelt ist und daß, vorzugsweise, der erzeugte Strom in das öffentliche Stromnetz eingespeist wird.

15. Gebäude nach einem der Ansprüche 12 bis 14, **dadurch gekennzeichnet, daß** der Generator (11) mit einem Akkumulator als Energiespeicher gekoppelt ist.

16. Verwendung von thermoelektrischen Generatoren (11) zur Umwandlung von Wärme, insbesondere Wärmestrahlung in Strom im Bereich der Gebäudehülle (2) eines Gebäudes (1), wobei die Generatoren (11) unter oder hinter der Gebäudeaußenhaut (3) der Gebäudehülle (2) des Gebäudes (1) angeordnet werden, und von der Gebäudeaußenhaut (3) abgegebene und/oder durchgelassene Wärme, insbesondere Infrarotstrahlung, in Strom umwandeln, wobei wenigstens ein thermoelektrischer Generator (11) einem Gebäudegrundelement zugeordnet ist, **dadurch gekennzeichnet, dass** der Generator (11) auf der der Gebäudeaußenhaut (3) zugewandten Außenseite des Gebäudegrundelements angeordnet ist.

## Claims

1. Building element (4) of a building envelope (2) of a building (1) having or forming a building shell (3), having a building base element to be arranged under or behind the building shell (3) and at least one thermoelectric generator (11) assigned to the building base element for conversion of heat, particularly heat radiation into electricity, **characterized in that** the generator (11) is arranged on the outside of the building base element facing the building shell (3).

2. A building element according to claim 1, **characterized in that** the generator (11) is provided on a supporting structure means, a building plate, an insulating wall panel or a sarking or underlay membrane (9) as a building base element.

3. A building element according to claim 1 or 2, **characterized in that** the generator (11) is firmly attached to the building base element or the shell element (14), in particular is stuck, or integrated in it.

4. A building element according to one of the previous claims, **characterized in that** the generator (11) is designed in a flexible or film-like manner.

5. A building element according to one of the previous claims, **characterized in that** the generator (11) is designed and optimized for the transformation of infrared radiation, particularly with a wave length in the range of between 2 and 20 µm, preferably between 7 and 13 µm and particularly between 8 and 10 µm.

6. A building element according to one of the previous claims, **characterized in that** in addition at least one photovoltaic- and/or solar thermal energy means is provided.

7. A building envelope (2) of a building (1) having at least one building element (4, 5) according to one of the previous claims and an external building shell (3), wherein the building element (4, 5) has at least one thermo-electric generator (11) for the conversion of heat , particularly heat radiation, into electricity.

8. A building envelope according to claim 7, **characterized in that** a cooling device is assigned to the generator (11) on the inside.

9. A building envelope according to claim 7 or 8, **characterized in that** the building element (4, 5) is provided in predominantly sunny areas of the building envelope (2), particularly in areas of the building envelope (2) oriented toward the east, south and/or west.

10. A building envelope according to one of the claims 7 to 9. **characterized in that** the building shell (3) has at least one transparent shell element (14).

11. A building envelope according to one of the claims 7 to 10, **characterized in that** the building shell (3) is provided on the outside at least in certain areas with a coating (16) for increasing the heating.

12. A building (1) with a building envelope (2) according to one of the claims 7 to 11.

13. A building according to claim 12, **characterized in that** the generator (11) is coupled with at least one consumer in the building (1).

14. A building according to claim 12 or 13, **characterized in that** the generator (11) is coupled with an inverter and that, preferably, the electricity generated is fed into the public electricity grid.

15. A building according to one of the claims 12 to 14, **characterized in that** the generator (11) is coupled with an accumulator battery for energy storage.

16. The use of thermoelectric generators (11) for the conversion of heat, particularly heat radiation into electricity in the area of the building envelope (2) of a building (1), wherein the generators (11) are arranged under or behind the building shell (3) of the building envelope (2) of the building (1), and convert heat given off and/or transmitted from the building shell (3), in particularly infrared radiation, into electricity, wherein at least one thermoelectric generator (11) is assigned to a base element, **characterized in that** the generator (11) is arranged on the outside of the building base element facing the building shell (3).

## Revendications

1. Élément de bâtiment (4) d'une enveloppe de bâtiment (2) d'un bâtiment (1) présentant ou formant un revêtement de bâtiment (3), comprenant un élément de base de bâtiment à agencer sous ou derrière le revêtement du bâtiment (3) et au moins un générateur thermoélectrique (11) adjoint à l'élément de base du bâtiment destiné à la transformation de chaleur, en particulier de rayonnement thermique, en électricité, **caractérisé en ce que** le générateur (11) est agencé sur le côté extérieur de l'élément de base du bâtiment dirigé vers le revêtement du bâtiment (3).

2. Élément de bâtiment selon la revendication 1, **caractérisé en ce que** le générateur (11) est prévu comme élément de base du bâtiment au niveau d'un moyen de bâti de support, d'un panneau de bâtiment, d'un panneau isolant ou d'une voie de basse tension ou de couverture inférieure (9).

3. Élément de bâtiment selon la revendication 1 ou 2, **caractérisé en ce que** le générateur (11) est relié à demeure, en particulier collé, avec l'élément de base du bâtiment ou l'élément de revêtement (14) ou **en ce qu'**il est intégré dans celui-ci.

4. Élément de bâtiment selon l'une des revendications précédentes, **caractérisé en ce que** le générateur (11) est réalisé de façon flexible ou à la manière d'une feuille.

5. Élément de bâtiment selon l'une des revendications précédentes, **caractérisé en ce que** le générateur (11) est réalisé et optimisé afin de transformer le rayonnement infrarouge, en particulier à une longueur d'onde comprise entre 2 et 20 µm, de préférence entre 7 et 13 µm et en particulier entre 8 et 10 µm.

6. Élément de bâtiment selon l'une des revendications précédentes, **caractérisé en ce qu'**il est prévu en complément au moins un moyen d'énergie photovoltaïque et/ou de thermie solaire.

7. Enveloppe de bâtiment (2) d'un bâtiment (1) comprenant au moins un élément de bâtiment (4, 5) selon l'une des revendications précédentes et un revêtement de bâtiment (3) extérieur, étant entendu que l'élément de bâtiment (4, 5) présente au moins un générateur thermoélectrique (11) destiné à la transformation de chaleur, en particulier de rayonnement thermique, en électricité.

8. Enveloppe de bâtiment selon la revendication 7, **caractérisée en ce qu'**une installation de refroidissement est adjointe au générateur (11) du côté intérieur.

9. Enveloppe de bâtiment selon la revendication 7 ou 8, **caractérisée en ce que** l'élément de bâtiment (4, 5) est prévu dans des zones majoritairement exposées au soleil de l'enveloppe du bâtiment (2), en particulier dans des zones orientées vers l'est, le sud et/ou l'ouest de l'enveloppe du bâtiment (2).

10. Enveloppe de bâtiment selon l'une des revendications 7 à 9, **caractérisée en ce que** le revêtement du bâtiment (3) présente au moins un élément d'enveloppe transparent (14).

11. Enveloppe de bâtiment selon l'une des revendications 7 à 10, **caractérisée en ce que** le revêtement du bâtiment (3) est prévu du côté extérieur, au moins sur une zone partielle, avec un enrobage (16) destiné à augmenter le réchauffement.

12. Bâtiment (1) comprenant une enveloppe de bâtiment (2) selon l'une des revendications 7 à 11.

13. Bâtiment selon la revendication 12, **caractérisé en ce que** le générateur (11) est couplé avec au moins un consommateur dans le bâtiment (1).

14. Bâtiment selon la revendication 12 ou 13, **caractérisé en ce que** le générateur (11) est couplé avec un onduleur et **en ce que** de préférence, le courant produit est injecté dans le réseau électrique public.

15. Bâtiment selon l'une des revendications 12 à 14, **caractérisé en ce que** le générateur (11) est couplé avec un accumulateur comme réservoir d'énergie.

16. Utilisation de générateurs thermoélectriques (11) pour la transformation de chaleur, en particulier de rayonnement thermique, en électricité dans la zone de l'enveloppe de bâtiment (2) d'un bâtiment (1), étant entendu que les générateurs (11) sont agencés sous ou derrière le revêtement du bâtiment (3) de l'enveloppe de bâtiment (2) du bâtiment (1) et transforment la chaleur, en particulier le rayonnement infrarouge, que le revêtement du bâtiment (3) émet et/ou laisse passer en électricité, étant entendu qu'un élément de base du bâtiment est adjoint à au moins un générateur thermoélectrique (11), **caractérisée en ce que** le générateur (11) est agencé sur le côté extérieur de l'élément de base du bâtiment dirigé vers le revêtement du bâtiment (3).
